# EUROPÄISCHE PATENTANMELDUNG

(11) **EP 0 584 386 A1**
(43) Veröffentlichungstag der Anmeldung: **02.03.1994**
(21) Anmeldenummer: 92114507.4
(22) Anmeldetag: 26.08.1992
(51) Int. Cl.: H05K 3/42

(54) **Leiterplatte und Herstellungsverfahren für Leiterplatten**

(71) Anmelder: INTERNATIONAL BUSINESS MACHINES CORPORATION, Armonk, N.Y. 10504 (US)
(72) Erfinder: Sippel, Gerhard, W-7034 Gärtringen (DE)
(74) Vertreter: Rach, Werner, Dr.

(57) **Zusammenfassung**

Es wird ein Verfahren mit mehreren Verfahrensvarianten vorgestellt, das es ermöglicht, die Schichtdicke der leitenden Schichten auf einer Leiterplatte von der Schichtdicke der leitenden Schichten in den Bohrungen zu entkoppeln. Dies erfolgt, indem zunächst die Oberflächenstruktur der Leiterplatte, insbesondere die Leiterzüge (3), fertiggestellt wird, diese dann durch eine Lötstopmaske (7) abgedeckt wird und erst anschließend die Metallisierung (9) der durch Belichtung und Entwicklung der Lötstopmaske freigelegten Bohrungen (4) und eventuell auch von Lands und Pads durchgeführt wird.

## Beschreibung

Die Erfindung befaßt sich mit Leiterplatten und mit Verfahren zu ihrer Herstellung.

Leiterplatten werden bisher gefertigt, indem die sogenannten Innenlagen, d.h. die leitenden Bereiche der Leiterplatte mit sowohl horizontal als auch vertikal dazwischenliegenden isolierenden Schichten in Sandwichbauweise aufgebaut werden. Dies kann auf viele verschiedene Weisen erfolgen, die z.B. im "Handbuch der Leiterplattentechnik", Band 2, 1991, E. G. Leuze Verlag, Saulgau, Deutschland dargestellt werden.

Liegt ein solches, üblicherweise durch Lamination hergestelltes Substrat vor, wird es mit einer Metallfolie, in der Regel mit Kupferfolie, ein- oder beidseitig beschichtet.

Anschließend werden in das metallbeschichtete Substrat Durchgangs- und/oder Sacklöcher gebohrt und diese von Bohrrückständen gereinigt.

Nun werden in der Regel die Bohrungen im Substrat und auch die Oberfläche ganz (full panel plate) oder nur das Leiterbild (pattern plate) einer galvanischen Metallabscheidung, z.B. in einem Kupferbad, unterzogen. Auf der Oberfläche wird das Metall somit auf die Metallfolie, in den Bohrungen direkt auf das aus Leiterzugebenen und Isolationsmaterial bestehende Substrat aufgebracht.

Das Substrat wird auf seiner ganzen Oberfläche mit Photoresist beschichtet, dieser musterförmig belichtet und entwickelt, wobei im Bereich der Bohrungen ein sogenanntes "Tenting", ein Abdecken der Bohrungen mit Photoresist erfolgt. In den übrigen Bereichen der Oberfläche werden hierdurch die späteren Leiterzüge definiert.

Im nächsten Schritt wird das Metall, also die galvanisch aufgebrachte Schicht und die Folie, entfernt, z.B. durch einen Ätzvorgang, und der Photoresist gestrippt. Es bleibt somit das durch das "Tenting" geschützte Metall in den Bohrungen und in den übrigen Bereichen das durch Photoresist geschützte Metall stehen.

Als letzter Schritt wird eine Lötstopmaske auf die Oberfläche des Substrates aufgetragen, belichtet und entwickelt. Danach können noch Test- und Trennschritte durchgeführt werden.

Auf diese Art und Weise werden Leiterplatten erhalten, bei denen die Metallschichtdicken auf der Leiterplattenoberfläche und in den Bohrungen miteinander gekoppelt sind. Da eine bestimmte Mindestschichtdicke des Metalls in den Bohrungen vorliegen muß, können mit diesem Verfahren, bei dem hohe Metallschichtdicken an der Oberfläche (Metallfolie und galvanisch abgeschiedenes Metall) vorliegen, kaum sogenannte "Fine-Line Produkte", d.h. solche mit Leiterzugbreiten von weniger als etwa 75 µm (ca. 3 mil), hergestellt werden.

Aufgabe der Erfindung ist es somit, die Metallisierung der Bohrungen von der der Oberfläche zu entkoppeln.

Diese Aufgabe wird erfindungsgemäß dadurch gelöst, daß nach dem Einbringen der Bohrungen 4 in das Substrat 1 und vor dem Aufbringen des leitenden Materials 9 in den Bohrungen 4 eine Lötstopmaske 7 auf die Oberfläche des Substrats 1 aufgebracht, belichtet und entwickelt wird.

In den Unteransprüchen 4 bis 10 sind weitere vorteilhafte Ausführungen des erfindungsgemäßen Verfahrens dargestellt.

Anhand des neuen Verfahrens können Leiterplatten mit Leiterzügen aus einem leitenden Material und mit Bohrungen, die mit einem leitenden Material beschichtet sind, hergestelllt werden, bei denen die Schichtdicke des leitenden Materials an einer Oberfläche der Leiterplatte unabhängig von der Schichtdicke des leitenden Materials in den Bohrungen wählbar ist.

Es können somit Fine-Line Leiterplatten hergestellt werden, bei denen die Schichtdicke des leitenden Materials an der Oberfläche der Leiterplatte etwa 10 bis 40 µm und die Schichtdicke des leitenden Materials in den Bohrungen etwa 5 bis 30 µm beträgt, und daß vorzugsweise die Schichtdicke des leitenden Materials an der Oberfläche der Leiterplatte etwa 15 bis 18 µm und die Schichtdicke des leitenden Materials in den Bohrungen etwa 23 bis 28 µm beträgt.

Im folgenden wird das erfindungsgemäße Verfahren mit mehreren Verfahrensvarianten anhand von Zeichnungen näher erläutert.

Es zeigt
- Fig.1: eine schematische Darstellung einer Verfahrensvariante, bei der die Bohrung vor dem Fertigstellen der Leiterzüge eingebracht wird,
- Fig. 2: eine schematische Darstellung einer Verfahrensvariante, bei der die Bohrung nach dem Fertigstellen der Leiterzüge in einem Bereich, in dem die Metallfolie nicht abgetragen wurde, eingebracht wird,
- Fig. 3: eine schematische Darstellung einer Verfahrensvariante, bei der die Bohrung nach dem Fertigstellen der Leiterzüge in einem Bereich, in dem die Metallfolie abgetragen wurde, eingebracht wird.

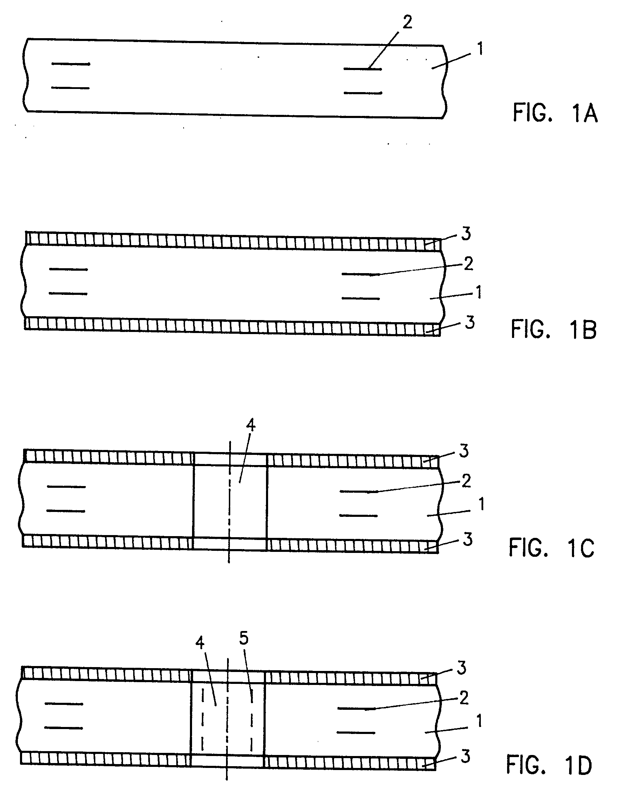

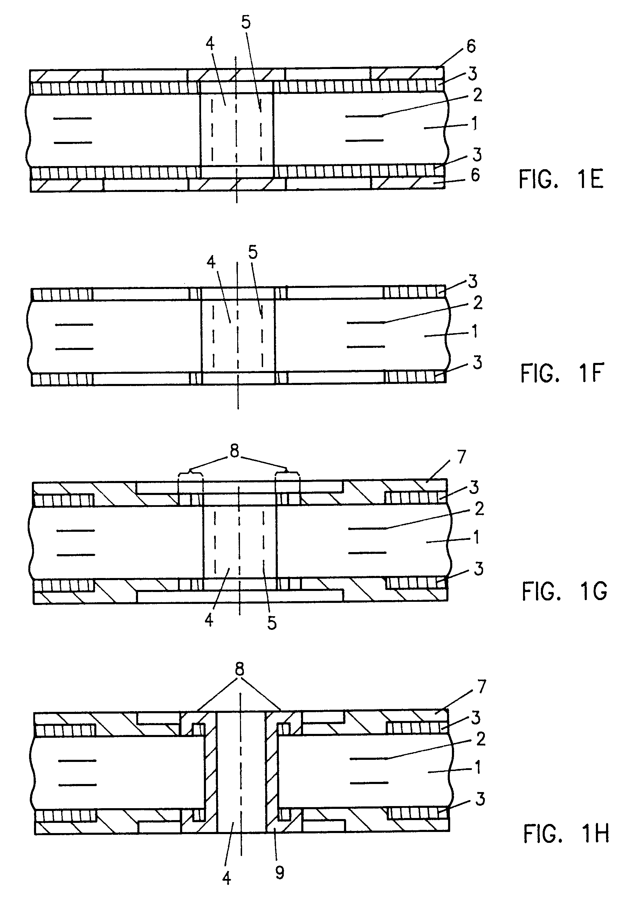

Wie in Fig. 1 dargestellt, wird bei der ersten Verfahrensvariante zunächst ein Substrat 1 mit allen für die Leiterplatte erforderlichen Innenlagen 2 auf bekannte Weise, z.B. durch Lamination, hergestellt (Schritt a.) und b.)). Das Substrat 1 besteht somit aus isolierenden (z.B. FR-4, Polyimide) und leitenden Lagen (z.B. Kupfer), die jeweils unterschiedlich strukturiert sein können.

Im z.B. gleichzeitig mit Schritt a.) erfolgenden Schritt b.) wird auf eine oder beide Oberflächen des Substrats 1 eine Metallfolie 3, z.B. eine Kupferfolie, von geringer Dicke, in der Regel unter 40 µm, aufgebracht. Das Aufbringen der Folie 3 kann beispielsweise durch Lamination erfolgen.

Anschließend (Schritt c.)) werden dann Bohrungen 4 in das Substrat 1 eingebracht, die sowohl Durchgangs- als auch Sacklöcher sein können und zum Verbinden der leitenden Lagen dienen. Als Bohrtechniken kommen mechanische und physikalische Verfahren (wie Spiralbohrer und Laser) in Frage. Durch geeignete Registrationsverfahren muß hierbei sichergestellt werden, daß die Bohrungen 4 in Bezug auf die Innenlagen 2 richtig positioniert sind. Die Bohrungen werden gereinigt, z.B. durch chemische Reinigungsverfahren.

Nun werden die Bohrungen 4 mit einem Konditioniermedium 5, wie beispielsweise gasförmigem Schwefeltrioxid, während 1 bis 2 Minuten bei Raumtemperatur für die spätere Metallisierung vorbereitet (Schritt d.)). Bei der Reaktion des Konditionsiermediums 5 mit der Kunststoffoberfläche werden funktionelle Gruppen gebildet, die eine Belegung mit Palladiumkeimen (Aktivierung) und eine spätere chemische Metallisierung ermöglichen. SO₃ hat gegenüber anderen Konditioniermedien, z.B. metallischen, den Vorteil, daß es nicht elektrisch aktiv ist. Somit kommt es an Stellen, an denen eine Abdeckung der konditionierten Bereiche erfolgt, bei Verwendung von SO₃ nicht zu den bekannten elektronischen Effekten, die beispielsweise zu Kurzschlüssen führen können. Außerdem bindet SO₃ sehr gut die bei dem Aktivierungsschritt aufgebrachten Edelmetallkatalysatoren, wie PD²⁺, woraus eine bessere Adhäsion der chemischen Metallisierung folgt.

Im folgenden Schritt e.) wird Photoresist 6 auf die Substratoberfläche aufgebracht, wobei auch die Bohrungen 4 abgedeckt werden sollten (sogenanntes "Tenting"). Es können herkömmliche Photoresiste verwendet werden, allerdings bieten sich beispielsweise dünn auftragbare Trockenresiste an, mit denen die Herstellung von Fine-Line-Produkten möglich wird. Der Photoresist 6 wird musterförmig (z.B. durch eine Maske) belichtet und entwickelt. Über den Bohrungen 4 und um diese herum bleibt jeweils Photoresist 6 stehen und auf den übrigen Bereichen der Substratoberfläche werden durch verbleibenden Photoresist 6 die späteren Leiterzüge definiert. Auch bei diesem Schritt muß durch ein Registrierverfahren sichergestellt werden, daß die späteren Leiterzüge in Bezug auf die Bohrungen 4 richtig positioniert sind und daß die Bohrungen gut abgedeckt sind.

Danach wird die Metallfolie 3 dort, wo kein Photoresist 6 vorliegt, durch ein geeignetes Verfahren abgetragen, z.B. durch einen Ätzprozeß (Schritt f.)). Desweiteren wird der Photoresist 6 entfernt. Die Leiterzugstrukturen wurden somit auf die Metallfolie 3 übertragen und die Anschlußflächen wie Lands (ringförmige Anschlußflächen rund um die Bohrungen) und Pads (Anschlußflächen ohne Bohrung) auf der Metallfolie 3 ausgebildet.

In Schritt g.) wird eine Lötstopmaske 7 auf die Oberfläche des Substrates 1 aufgebracht, belichtet und entwickelt, wobei die Lötstopmaske insbesondere über den Bohrungen 4 sowie um diese herum in einem Bereich 8, der zumindest die dort für das Erzeugen eines Lands stehengelassene Metallfolie umfaßt, entfernt wird. Die übrige Oberfläche des Substrates 1 wird von der Lötstopmaske 7, die auch während späterer Bearbeitungsschritte darauf verbleiben kann, abgedeckt. Dabei muß ein leisungsfähiges Registrierverfahren für die richtige Positionierung der Öffnungen in der Lötstopmaske 7 sorgen.

Somit ist das auf der Oberfläche abgedeckte Substrat 1 mit freigelegter Bohrung 4 und freigelegter Metallfolie auf dem Bohrungsrand 8 bereit für eine Metallisierung 9, die in Schritt h.) erfolgt. In der Regel wird es sich dabei um eine Metallisierung in einem chemischen Metallbad, z.B. einem chemischen Kupferbad handeln, wobei prinzipiell auch andere Metallisierungsverfahren in Frage kommen. Eine vorab erfolgende Vernickelung in einem chemischen Nickelbad könnte - beispielsweise bei anschließender Verkupferung - vorteilhaft sein, da sie zu einer Verbesserung der Haftung der Metallisierung 9 auf dem Substrat 1 führt.

Mit diesem Verfahren wird es möglich, die Dicke der Metallisierung im Bereich der Bohrungen 4 unabhängig von der der Leiterzüge zu wählen. Durch eine Kombination von Additiv-und Subtraktivverfahren können die Vorteile beider miteinander kombiniert werden. Es werden gegenüber bekannten Verfahren höhere "aspect-ratios" in den Bohrungen, das heißt gleichmäßigere Metallisierung auch in tiefen, feinen Bohrungen, erzielt. Die Varianz der Schichtdicke an der Oberfläche ist bei der Verwendung von Kupferfolien deutlich geringer als bei heutigen Prozessen, bei denen auf eine Metallfolie noch zusätzliches Metall galvanisch aufgebracht wird. Zusätzlich bringt das Strukturieren der Metallfolie allein weniger Materialverluste als das einer Doppelschicht aus Metallfolie 3 und Metallisierung 9 mit sich.

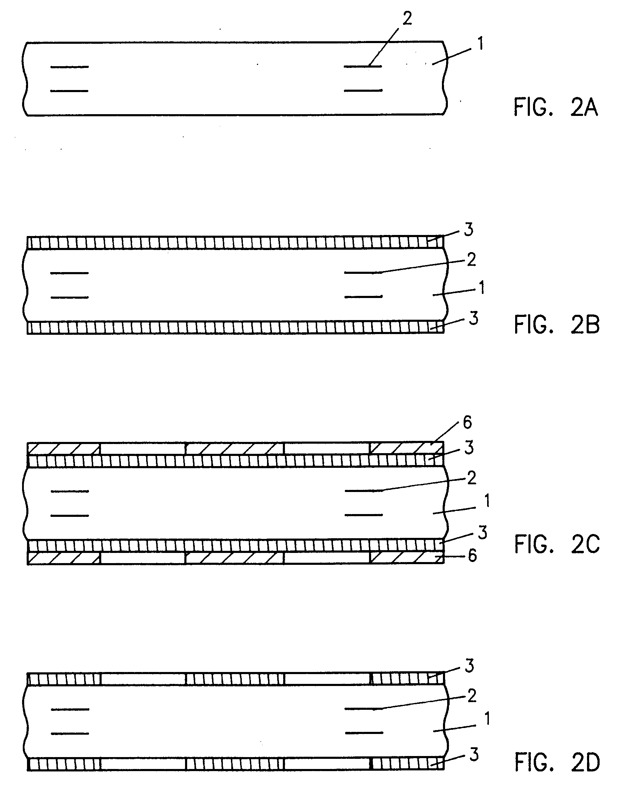

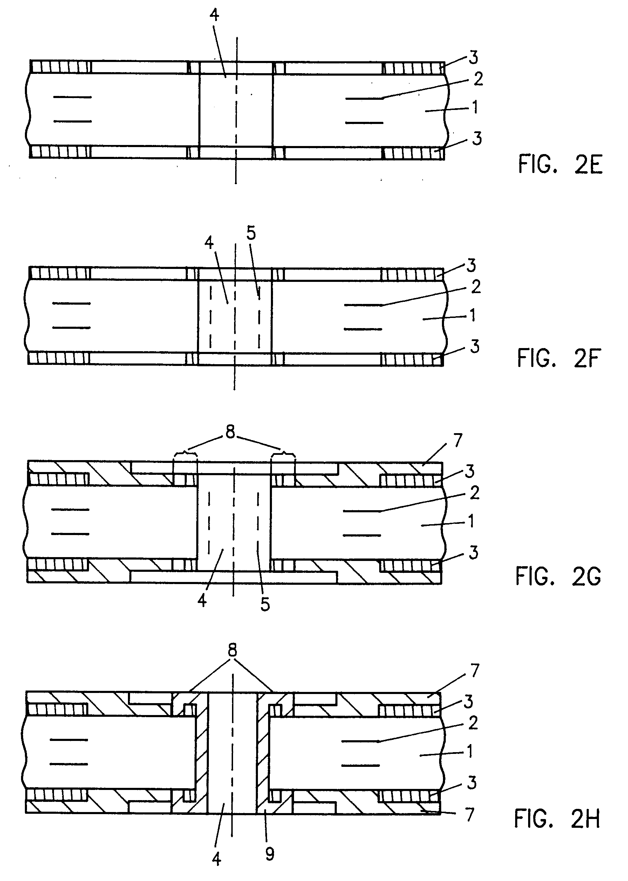

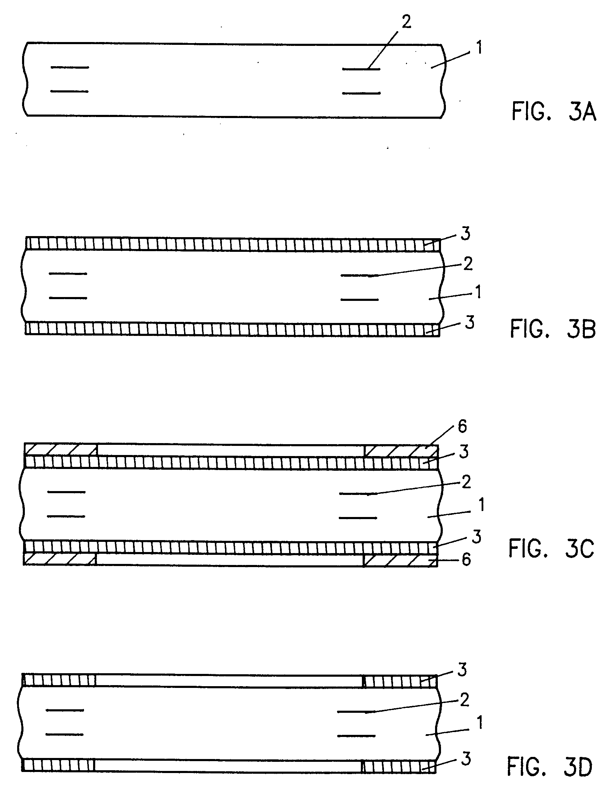

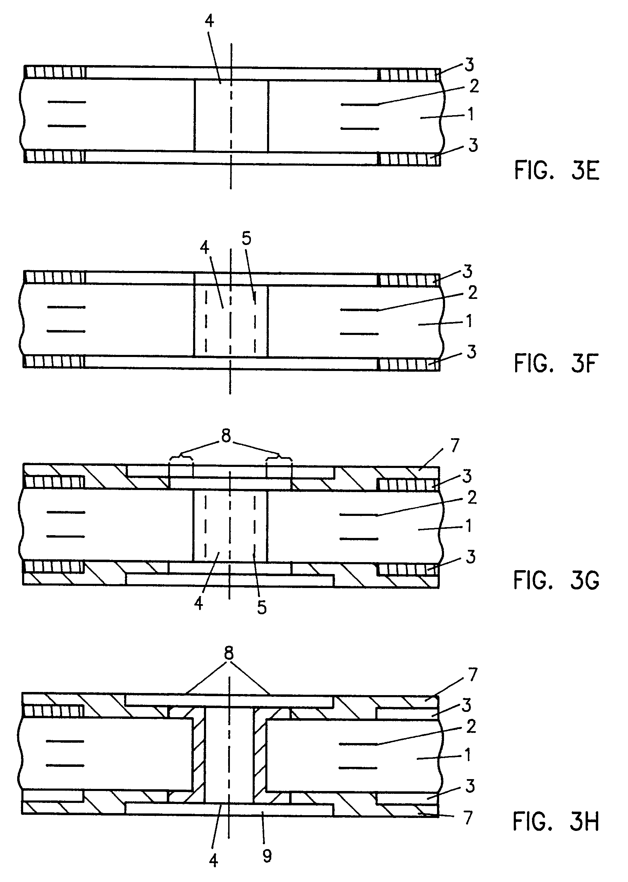

Es bietet sich auch an, die Bohrungen 4 erst dann in das Substrat 1 einzubringen, wenn die Leiterzüge an deren Oberfläche bereits erstellt sind. Diese Möglichkeit wird anhand der Fig. 2 und 3 erläutert. Bei diesen beiden Verfahrensvarianten sind die Schritte a.) und b.), die Herstellung eines Substrates 1 mit bereits fertigen Innenlagen 2 und das Aufbringen einer Metallfolie 3 auf dieses identisch mit den Schritten a.) und b.) der ersten Variante.

Bei der zweiten Variante (Fig. 2) wird daraufhin in Schritt c.) auf die Oberfläche des Substrates Photoresist 6 aufgebracht und belichtet, wobei nach der Belichtung auch in den Bereichen, in denen später eine Bohrung eingebracht werden soll, Photoresist 6 vorliegt.

Im darauffolgenden Schritt d.) wird dann die Metallfolie 3 an Stellen, an denen kein Photoresist 6 vorliegt, entfernt und dann der Photoresist 6 abgetragen.

Nun können Bohrungen 4 in das Substrat 1 eingebracht werden, die wiederum Durchgangs- oder Sacklöcher sein können (Schritt e.)). Wie bereits in Schritt c.) erläutert, werden bei der zweiten Variante die Bohrungen 4 in einem Bereich eingebracht, in dem vorher Photoresist 6 vorlag und der somit noch Metallfolie 3 aufweist.

Anschließend erfolgt in Schritt f.) analog zu Schritt d.) der ersten Variante die Konditionierung der Bohrung 4 mit einem Konditioniermedium 5.

Damit liegt in Schritt g.) der zweiten Variante der gleiche Zustand wie in Schritt g.) der ersten Variante vor und die weitere Verfahrensweise ist identisch.

Eine präzise Registration muß hier bei mehreren Schritten gewährleistet sein: Beim Herstellen der Leiterzüge, die über die Bohrungen 4 zu den Innenlagen 2 registriert werden müssen und beim Freilegen der Lötstopmaske bezüglich der Lage der Bohrungen, Pads etc.

Diese Vorgehensweise hat gegenüber der ersten Variante vor allem den Vorteil, daß kein "Tenting" der Bohrungen mehr erforderlich ist. Durch das Wegfallen des "Tentings" wird eine bedeutende Fehlerquelle beim Herstellen von Leiterplatten eliminiert, da beim relativ häufigen Auftreten von "broken tents", dem Bruch des "Tentings", Ausschuß (ausgeätzte Bohrungen) entsteht.

Bei der dritten Verfahrensvariante, die in Fig. 3 dargestellt ist, wird im Gegensatz zur zweiten Variante die Bohrung 4 in Schritt e.) in einem Bereich des Substrates 1 eingebracht, in dem keine Metallfolie 3 mehr vorliegt. Nach Konditionierung (Schritt f.)), Aufbringen einer Lötstopmaske 7 und Metallisierung 9, die alle analog zu Variante 2 verlaufen, liegt hier im Bereich 8 um die Ränder der Bohrung keine Doppelschicht aus Metallfolie 3 und aufgebrachter Metallisierung 9, sondern nur die letztere vor.

Mit diesem Verfahren können alle Anschlußflächen, wie Lands und Pads in dem Metallisierungsschritt h.) aufgebracht werden. Es ist damit auch möglich, ein sogenanntes "landless design" durchzuführen, d.h., das leitende Material der Bohrungen 4 direkt mit dem der Leiterzüge zu verbinden, was einen bedeutenden Platzgewinn mit sich bringt. Gegenüber der zweiten Variante hat diese noch den Vorteil, daß das Registrierproblem, das dort beim Freilegen der Lötstopmaske in Bezug auf die Lands auftritt, hier entfällt. Außerdem bietet sich durch die Tatsache, daß alle leitenden Strukturen auf der Oberfläche des Substrates 1, die keine Leiterzüge sind, erst in dem finalen Metallisierungsschritt erzeugt werden, die Möglichkeit, Teile, die bereits nach dem kritischen Bohrschritt als Ausschuß vorliegen, nicht dem aufwendigen Metallisierungsschritt unterziehen zu müssen.

Alle drei Verfahrensvarianten erfordern eine Lötstopmaske 7, die nicht metallisiert wird, die den Metallisierungselektrolyten nicht vergiftet und die nicht elektrolytisch unterwandert wird. Eine solche Lötstopmaske 7 kann beispielsweise ein lötbeständiger Photoresist, wie ein photostrukturierbares Epoxydharz, sein.

Die oben beschriebenen Verfahren ermöglichen es, Leiterplatten herzustellen, bei denen die Schichtdicke des leitenden Materials an der Oberfläche der Leiterplatte unabhängig von der Schichtdicke des leitenden Materials in den Bohrungen gewählt werden kann. Die Schichtdicke an der Oberfläche muß also nicht mehr über der in den Bohrungen liegen, sondern beide können im Rahmen des technisch Sinnvollen frei bestimmt werden. So können die Schichtdicken der Leiterzüge z.B. im Bereich von ca. 10 bis 40 µm und die in den Bohrungen bei ca. 5 bis 30 µm liegen, wobei es durchaus sinnvoll sein kann, daß die erste beispielsweise ca. 15 bis 18 µm und die zweite ca. 23 bis 28 µm beträgt. Dadurch wird es möglich, auf der Oberfläche der Leiterplatte eine Feinstleitertechnik mit hoher Verdrahtungsdichte und gleichzeitig eine gute Metallisierung der Bohrungen zu erreichen. Dies wird durch die Möglichkeit eines "landless design" bei den Verfahrensvarianten 2 und 3 noch unterstützt, da durch den dabei erzielten Platzgewinn an der Oberfläche die Verdrahtungsdichte weiter gesteigert werden kann.

## Patentansprüche

1. Leiterplatte mit Leiterzügen aus einem leitenden Material und mit Bohrungen, die mit einem leitenden Material beschichtet sind, dadurch gekennzeichnet, daß die Schichtdicke des leitenden Materials an einer Oberfläche der Leiterplatte unabhängig von der Schichtdicke des leitenden Materials in den Bohrungen wählbar ist.

2. Leiterplatte gemäß Anspruch 1, dadurch gekennzeichnet, daß die Schichtdicke des leitenden Materials an der Oberfläche der Leiterplatte etwa 10 bis 40 µm und die Schichtdicke des leitenden Materials in den Bohrungen etwa 5 bis 30 µm beträgt, und daß vorzugsweise die Schichtdicke des leitenden Materials an der Oberfläche der Leiterplatte etwa 15 bis 18 µm und die Schichtdicke des leitenden Materials in den Bohrungen etwa 23 bis 28 µm beträgt.

3. Verfahren zum Herstellen einer Leiterplatte aus einem Substrat (1) gemäß Anspruch 1 oder Anspruch 2, dadurch gekennzeichnet, daß nach dem Einbringen der Bohrungen (4) in das Substrat (1) und vor dem Aufbringen des leitenden Materials (9) in den Bohrungen (4) eine Lötstopmaske (7) auf die Oberfläche des Substrats (1) aufgebracht, belichtet und entwickelt wird.

4. Verfahren zum Herstellen von Leiterplatten gemäß Anspruch 3, gekennzeichnet durch folgende Verfahrenschritte:
a.) Herstellen eines Substrates (1);
b.) Aufbringen von Metallfolie (3) auf das Substrat (1);
c.) Einbringen einer Bohrung (4) in das Substrat (1);
d.) Behandeln der Bohrung (4) mit einem Konditioniermedium (5);
e.) Beschichten des Substrates 1 mit Photoresist (6), wobei die Bohrung (4) abgedeckt wird; musterförmiges Belichten und Entwickeln des Photoresists (6);
f.) Abtragen der Metallfolie (3) an Stellen, an denen kein Photoresist (6) vorliegt; Entfernen des Photoresists (6);
g.) Aufbringen einer Lötstopmaske (7) auf die Oberfläche des Substrates (1);
musterförmiges Belichten und Entwickeln der Lötstopmaske (7), wobei die Lötstopmaske (7) in den Bereichen der Bohrung (4) entfernt wird;
h.) Aufbringen einer Metallisierung (9) auf die Bereiche, in denen keine Lötstopmaske (7) vorliegt.

5. Verfahren zum Herstellen von Leiterplatten gemäß Anspruch 3, gekennzeichnet durch folgende Verfahrensschritte:
a.) Herstellen eines Substrates (1);
b.) Aufbringen von Metallfolie (3) auf das Substrat (1);
c.) Beschichten des Substrates (1) mit Photoresist (6);
musterförmiges Belichten und Entwickeln des Photoresists (6);
d.) Abtragen der Metallfolie (3) an Stellen, an denen kein Photoresist (6) vorliegt und Entfernen des Photoresists (6);
e.) Einbringen einer Bohrung (4) in das Substrat 1;
f.) Behandeln der Bohrung (4) mit einem Konditioniermedium (5);
g.) Aufbringen einer Lötstopmaske (7) auf die Oberfläche des Substrates (1);
musterförmiges Belichten und Entwickeln der Lötstopmaske (7), wobei die Lötstopmaske (7) in den Bereichen der Bohrungen (4) entfernt wird;
h.) Aufbringen einer Metallisierung (9) auf die Bereiche, in denen keine Lötstopmaske (7) vorliegt.

6. Verfahren gemäß Anspruch 5, dadurch gekennzeichnet, daß in Schritt e.) die Bohrung (4) in einem Bereich der Oberfläche des Substrates (1) eingebracht wird, in dem die Metallfolie (3) nicht abgetragen wurde, wobei um die Bohrung (4) herum Metallfolie (3) vorliegt, die in Schritt h.) metallisiert wird.

7. Verfahren gemäß Anspruch 5, dadurch gekennzeichnet, daß in Schritt e.) die Bohrung (4) in einem Bereich der Oberfläche des Substrats (1) eingebracht wird, in dem die Metallfolie (3) abgetragen wurde, wobei der Bereich der Bohrung (4) in Schritt h.) metallisiert wird.

8. Verfahren gemäß einem oder mehreren der Ansprüche 1 bis 7, dadurch gekennzeichnet, daß das Konditioniermedium (5) gasförmiges SO₃ ist.

9. Verfahren gemäß einem oder mehreren der Ansprüche 1 bis 8, dadurch gekennzeichnet, daß die Metallfolie (3) eine Kupferfolie ist und das Metallisieren mit Kupfer erfolgt.

10. Verfahren gemäß Anspruch 9, dadurch gekennzeichnet, daß vor dem Metallisieren mit Kupfer eine Nickelabscheidung erfolgt.
